# EUROPEAN PATENT APPLICATION

(11) **EP 4 456 144 A1**
(43) Date of publication of application: **30.10.2024**
(21) Application number: 22939806.0
(22) Date of filing: 18.10.2022
(51) Int. Cl.: H01L 29/78, H01L 29/423, H01L 29/417, H01L 21/336

(54) **SILICON CARBIDE SEMICONDUCTOR DEVICE AND MANUFACTURING METHOD THEREFOR**

(30) Priority: 24.04.2022 CN 202210433930; 24.04.2022 CN 202220975064 U
(71) Applicant: Hubei Jiufengshan Laboratory, Wuhan, Hubei 430070 (CN)
(72) Inventor: YUAN, Jun, Wuhan, Hubei 430070 (CN)
(74) Representative: KASTEL Patentanwälte PartG mbB
(86) International application number: PCT/CN2022/125790
(87) International publication number: WO 2023/206986

(57) **Abstract**

The present application discloses a silicon carbide semiconductor device and a manufacturing method therefor. The silicon carbide semiconductor device comprises: a silicon carbide epitaxial layer, provided with a first surface and a second surface which are opposite to each other, the first surface comprising a gate region and source regions located on two sides of the gate region, and a first trench being formed in the surface of the gate region; a first withstand voltage masking structure, formed in the silicon carbide epitaxial layer on the basis of the first trench; a gate structure, located in the first trench, the surface of the gate structure being provided with a metal gate; and a second withstand voltage masking structure, arranged in the surface of the source region, a metal source being arranged on the surface of the source region, and a well region being arranged in the first surface and located between the first trench and the second withstand voltage masking structure. According to the silicon carbide semiconductor device, a first withstand voltage masking structure is formed in the silicon carbide epitaxial layer on the basis of the first trench, and a second withstand voltage masking structure is formed in the surface of the source region, so that the withstand voltage performance of a corner region at the bottom of the first trench is improved, and the problem of breakdown in an electric field concentration region is solved.

## Description

This application claims priority to Chinese Patent Application No. 202210433930.0, titled "SILICON CARBIDE SEMICONDUCTOR DEVICE AND METHOD FOR MANUFACTURING THE SAME" and Chinese Patent Application No. 202220975064.3, titled "SILICON CARBIDE SEMICONDUCTOR DEVICE ", which are filed on April 24, 2022, with the China National Intellectual Property Administration, and are incorporated herein by reference in their entireties.

### FIELD

The present disclosure relates to the technical field of semiconductor devices, and in particular to a silicon carbide (SiC) semiconductor device and a method for manufacturing the SiC semiconductor device.

### BACKGROUND

Continuous development of science and technology renders more and more electronic apparatuses widely applied in people's daily life and work. These electronic apparatuses engender great convenience and are modern tools which are important and indispensable.

Integrated circuits are main structures for achieving various functions in the electronic apparatuses, and MOSFET devices are important electronic components in the integrated circuits. Silicon carbide MOSFET devices have become a major trend in the field due to their excellent characteristics in high-power applications.

When applied to high-power equipment, a silicon carbide semiconductor device may be subject to a strong electric field, and a portion under high electric field intensity is likely to break down.

### SUMMARY

In view of the above, a silicon carbide semiconductor device and a method for manufacturing the silicon carbide semiconductor device are provided according to embodiments of the present disclosure. Technical solutions are as follows.

A silicon carbide semiconductor device is provided according to embodiments of the present disclosure. The silicon carbide semiconductor device comprises: a silicon carbide epitaxial layer, where the silicon carbide epitaxial layer comprises a first surface and a second surface that are opposite to each other, the first surface comprises a gate region and a source region located on two sides of the gate region; a first trench, opened at the first surface in the gate region; a first voltage-resistant shielding structure, located in the silicon carbide epitaxial layer and formed through the first trench; a gate structure, located in the first trench; a gate metal, located on a surface of the gate structure; a second voltage-resistant shielding structure, embedded under the first surface in the source portion; a source metal, located on the first surface in the source region; and a doped well, embedded under the first surface and located between the first trench and the second voltage-resistant shielding structure.

In an embodiment, along a depth direction of the first trench, the first voltage-resistant shielding structure is located on a side of the doped well facing the second surface, and the first voltage-resistant shielding structure does not contact the doped well.

In an embodiment, the first trench is a first two-level stair trench. The gate structure comprises polysilicon filling the first trench, and a first insulating dielectric layer is located between a surface of the first trench and the polysilicon. The first voltage-resistant shielding structure comprises a doped region embedded under a side surface and a bottom surface of a level, which is close to the second surface, of the first two-level stair trench.

In an embodiment, with respect to the first surface, a depth of the doped well is less than a depth of a step surface between two levels of the first two-level stair trench. The first voltage-resistant shielding structure is located on a side of the step surface facing the second surface.

In an embodiment, the first trench is a first two-level stair trench. The first two-level stair trench is filled with polysilicon, and a first insulating dielectric layer is located between a surface of the first two-level stair trench and the polysilicon. A thickness of the insulating dielectric layer on a bottom surface of the first two-level stair trench is greater than a thickness of the insulating dielectric layer on side surfaces of two levels of the first two-level stair trench and a thickness of the insulating dielectric layer at a step surface between the two levels of the first two-level stair trench.

In an embodiment, a multi-level stair trench is located under the first surface in the source region. The multi-level stair trench is filled with polysilicon, and a second insulating dielectric layer is located between a surface of the multi-level stair trench and the polysilicon. The second voltage-resistant shielding structure comprises a doped region located in the silicon carbide epitaxial layer and formed through the multi-level stair trench.

In an embodiment, the first trench is a first two-level stair trench, the multi-level stair trench is a second two-level stair trench, and a depth of the first two-level stair trench is identical to a depth of the second two-level stair trench.

In an embodiment, the first trench is a first two-level stair trench, the multi-level stair trench is a three-level stair trench, and a depth of the three-level stair trench is greater than a depth of the first two-level stair trench.

In an embodiment, the second voltage-resistant shielding structure comprises a doped region of the silicon carbide epitaxial layer embedded under a side surface of each level, a step surface between every two adjacent levels, a bottom surface, and the first surface surrounding an opening, of the multi-level stair trench.

In an embodiment, a thickness of the second insulating dielectric layer on a bottom surface of the multi-level stair trench is greater than a thickness of the second insulating dielectric layer on a side surface of each level of the multi-level stair trench and a thickness of the second insulating dielectric layer on a step surface between every two adjacent levels of the multi-level stair trench.

In an embodiment, the second voltage-resistant shielding structure is embedded under the first surface in the source region and implanted with ions.

In an embodiment, a depth of implanting the ions is greater than or equal to a depth of the first trench.

A method for manufacturing any foregoing silicon carbide semiconductor device is provided according to an embodiment of the present disclosure. The method comprises: providing an epitaxial wafer, where the epitaxial wafer comprises a silicon carbide epitaxial layer, the silicon carbide epitaxial layer comprises a first surface and a second surface that are opposite to each other, the first surface comprises a gate region and a source region located on two sides of the gate region; forming a first trench in the gate region; forming a first voltage-resistant shielding structure in the silicon carbide epitaxial layer through the first trench; forming a gate structure in the first trench; forming a gate metal on a surface of the gate structure, and forming a source metal on a surface of the source region; where a second voltage-resistant shielding structure is embedded under the first surface in the source region, and a doped well is embedded under the first surface and located between the first trench and the second voltage-resistant shielding structure.

In an embodiment, the first trench is a first two-level stair trench, and a multi-level stair trench is formed in the source region. Forming the first voltage-resistant shielding structure and forming the second voltage-resistant shielding structure comprises: implanting, via the first two-level stair trench and under masking of a dielectric layer located on a side surface of another level of the first two-level stair trench close to the first surface, ions into a side surface and a bottom surface of a level of the first two-level stair trench close to the second surface to form the first voltage-resistant shielding structure embedded under the side surface and the bottom surface of the level of the first two-level stair trench; and implanting, via the multi-level stair trench, ions into a bottom surface, a step surface between every two adjacent levels, and a side surface of each level, of the multi-level stair trench to form the second voltage-resistant shielding structure in the silicon carbide epitaxial layer, where the second voltage-resistant shielding structure is embedded under the bottom surface, the one or more step surfaces, and the side surfaces of the multi-level stair trench.

In an embodiment, the first trench is a first two-level stair trench, and a multi-level stair trench is formed in the source region. The first two-level stair trench and the multi-level stair trench are filled with polysilicon. The gate structure comprises the polysilicon filling the first two-level stair trench. An insulating dielectric layer is disposed between a surface of the first two-level stair trench and the polysilicon filling the first two-level stair trench and between a surface of the multi-level stair trench and the polysilicon filling the multi-level stair trench. The gate structure comprises the polysilicon filling the first two-level stair trench. The gate metal is disposed on a surface of the polysilicon filling the first two-level stair trench, and the source metal is disposed on a surface of the polysilicon filling the multi-level stair trench.

In an embodiment, a thickness of the insulating dielectric layer on a bottom surface of the first two-level stair trench is greater than a thickness of the insulating dielectric layer on side surfaces of two levels of the first two-level stair trench and a thickness of the insulating dielectric layer on a step surface between the two levels. A thickness of the insulating dielectric layer on a bottom surface of the multi-level stair trench is greater than a thickness of the insulating dielectric layer on a side surface of each level of the multi-level stair trench and a thickness of the insulating dielectric layer on a step surface between every two adjacent levels of the multi-level stair trench.

In an embodiment, the multi-level stair trench is a second two-level stair trench, and a depth of the second two-level stair trench is identical a depth of the first two-level stair trench. Alternatively, the multi-level stair trench is a three-level stair trench, and a depth of the three-level stair trench is greater than a depth of the first two-level stair trench.

In an embodiment, forming the second voltage-resistant shielding structure comprises: performing ion implantation on the source region to form an ion-implanted portion, which serves as the second voltage-resistant shielding structure, where a depth of the ion implantation is greater than or equal to a depth of the first trench.

Hence, the silicon carbide semiconductor device and the method for manufacturing the silicon carbide semiconductor device are provided according to technical solutions of the present disclosure. The silicon carbide semiconductor device comprises: the silicon carbide epitaxial layer, where the silicon carbide epitaxial layer comprises the first surface and the second surface that are opposite to each other, the first surface comprises the gate region and the source region located on two sides of the gate region; the first trench, opened at the first surface in the gate region; the first voltage-resistant shielding structure, located in the silicon carbide epitaxial layer and formed through the first trench; the gate structure, located in the first trench; the gate metal, located on the surface of the gate structure; the second voltage-resistant shielding structure, embedded under the first surface in the source portion; and the source metal, located on the first surface in the source region. The doped well is embedded under the first surface and located between the first trench and the second voltage-resistant shielding structure. In the silicon carbide semiconductor device, the first voltage-resistant shielding structure is formed in the silicon carbide epitaxial layer through the first trench, and the second voltage-resistant shielding structure is formed on the source region. Thereby, voltage resistance at bottom corners of the first trench is improved, and breakdown is less likely to occur at a region subject to high electric field intensity.

### BRIEF DESCRIPTION OF THE DRAWINGS

In order to clarity illustration of the technical solutions according to embodiments of the present disclosure or conventional technology, hereinafter the drawings to be applied in embodiments of the present disclosure or technology are briefly described. Apparently, the drawings in the following descriptions are only some embodiments of the present disclosure, and other drawings may be obtained by those skilled in the art based on the provided drawings without creative efforts.

Structures, proportions, dimensions, and the like as shown in the drawings of this specification are intended for facilitating understanding and intelligibility for those skilled in the art in conjunction with content disclosed herein, not for limiting a condition of implementing the present disclosure, and hence do not represent practical techniques. Any structural modifications, changes in proportions, or adjustments in dimensions shall fall within the scope of the present disclosure as long as not affecting an effect or an objective of embodiments the present disclosure.
FIG. 1 is a schematic structural diagram of a double-diffusion MOSFET (DMOSFET).
FIG. 2 is a schematic structural diagram of a trench-gate MOSFET (UMOSFET).
FIG. 3 is a schematic structural diagram of a silicon carbide semiconductor device according to an embodiment of the present disclosure.
FIG. 4 is a schematic structural diagram of a silicon carbide semiconductor device according to another embodiment of the present disclosure.
FIG. 5 is a schematic structural diagram of a silicon carbide semiconductor device according to another embodiment of the present disclosure.
FIG. 6 is a schematic structural diagram of a silicon carbide semiconductor device according to another embodiment of the present disclosure.
FIGs. 7-29 are schematic diagrams of a process of a method for manufacturing a silicon carbide semiconductor device according to embodiments of the present disclosure.

### DETAILED DESCRIPTION OF EMBODIMENTS

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

Silicon carbide (SiC) is quite appealing in high-power electronics due to its excellent properties and has become an ideal material for power MOSFETs with high performances. In general, SiC-based vertical power MOSFET devices include lateral double-diffusion MOSFET (DMOSFET) and vertical trench-gate MOSFET (UMOSFET).

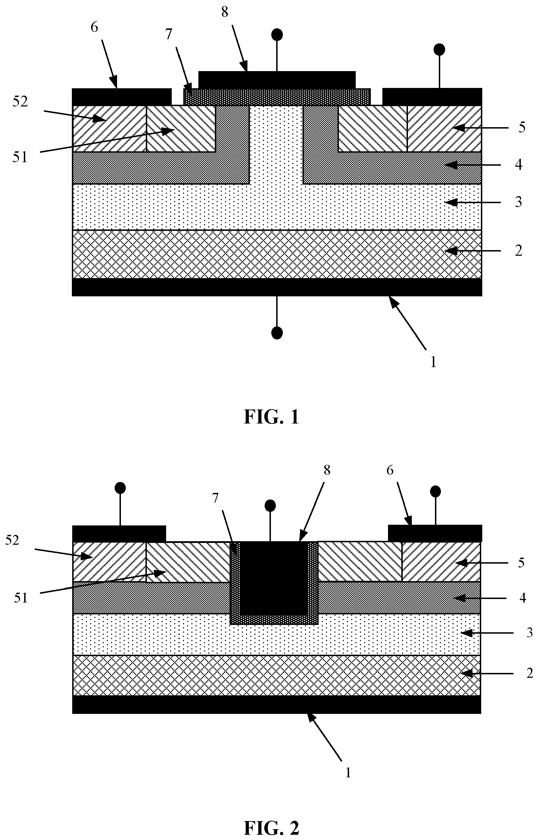

Reference is made to FIG. 1, which is a schematic structural diagram of a DMOSFET. The DMOSFET comprises an n+ (heavily n doped) substrate 2, an n- (lightly n doped) drift region 3 disposed on a surface of the substrate 2, a p-doped well 4 disposed in the drift region 3, and a source region 5 disposed in the p-doped well. The source region 5 comprises an n+ doped region 51 and a p+ (heavily p doped) doped region 52. A gate dielectric layer 7 is disposed on a surface of the drift region 3, and a gate electrode 8 is disposed on a surface of the gate dielectric layer 7. A drain electrode 1 is located on a surface of the substrate 2 facing away from the drift region 3.

The DMOSFET structure adopts planar diffusion. A gate made of a refractory material such as polysilicon serves as a mask, and a p-type base region and an n+ source region are defined by an edge of the gate. The name "DMOS" origins from double diffusion, in which a surface channel region is formed by using a difference between lateral diffusion in the p-type base region and lateral diffusion in the n+ source region.

Reference is made to FIG. 2, which is a schematic structural diagram of a UMOSFET. A difference from the structure as shown in FIG. 1 is that a U-shaped trench is provided in the UMOSFET. A surface of the U-shaped trench is covered with a gate dielectric layer 7, and the U-shaped trench is filled with a gate electrode 8. The name "UMOSFET", which is vertical and has a trench gate, origins from the U-shaped trench. The U-shaped trench is formed in a gate region through reactive ion etching. The U-shaped trench allows a high channel density (where the channel density is defined by a width of a channel in an active region), such that the characteristic ON-state resistance of the device is significantly reduced.

Some manufacturers have already launched commercial products of planar SiC MOSFETs after years of research in the field. Modern Techniques for conventional lateral DMOSFETs has reached a point at the On-resistance of a MOS cell cannot be reduced with miniaturization of the MOS, mainly due to limitation of resistance in a JFET neck region. That is, it is hard to decrease the ON-resistance per unit area to 2mΩ·cm² even when decreasing a dimension of photolithography. Such issues can be effectively addressed by using the U-shaped trench structure as shown in FIG. 2. The U-shaped trench structure utilizes trench etching techniques for manufacturing storage capacitors in memories, which turns a channel from horizontal to vertical. Compared with the conventional structures, the JFET neck resistance is eliminated, and a density of cells is greatly increased, which improves a capability of the power semiconductor in handling currents.

In conventional technology, the SiC-based UMOSFETs still have several problems in actual manufacturing and application.

First, a high electrical field in a drift region made of SiC results in a high electrical field on the gate dielectric layer. The problem is exacerbated at corners of the trench, and hence the gate dielectric layer is subject to rapid breakdown under a high drain voltage. Thereby, the UMOFETs have poor tolerance against harsh electrostatic environments and large voltage spikes in a circuit.

Second, a depth of ion implantation is limited, which makes it difficult to achieve protective and anti-surge structures for the trench gate through common techniques.

Third, when a single gate trench is rectangular or U-shaped, a thickness of the silicon dioxide layer, which is formed at a bottom of the gate trench through oxidation in a high-temperature furnace tube, is usually thin due to a property of silicon carbide. Accordingly, voltage resistance at the bottom of the trench is reduced, which lowers reliability of the device.

In order to address at least the above issues, a silicon carbide semiconductor device is provided according to technical solutions of the present disclosure. In the silicon carbide semiconductor device, a first voltage-resistant shielding structure is formed in the silicon carbide epitaxial layer through a first trench, and a second voltage-resistant shielding structure is formed in a source region. Thereby, voltage resistance at bottom corners of the first trench is improved, breakdown is less likely to occur at a region subject to high electric field intensity, electrostatic tolerance of the device against harsh environments is improved, and tolerance of the device against high-voltage spikes in circuitry is improved. Moreover, forming the first voltage-resistant shielding structure through the first trench is capable to increase a depth of ions implanted for forming the first voltage-resistant shielding structure. Hence, a variety of trench gate protection structures and anti-surge designs can be achieved. In addition, a thick insulating dielectric layer can be fabricated at a bottom of the trench, which addresses the issue that a thick silicon dioxide layer cannot be formed at the bottom of the trench through oxidation in common high-temperature furnace tubes. Hence, the voltage resistance at the bottom of the trench can be further improved, which increases reliability of the device.

Hereinafter the present disclosure is further illustrated in detail in conjunction with the drawings and specific embodiments, in order to elucidate and clarify objectives, features, and advantages of the present disclosure.

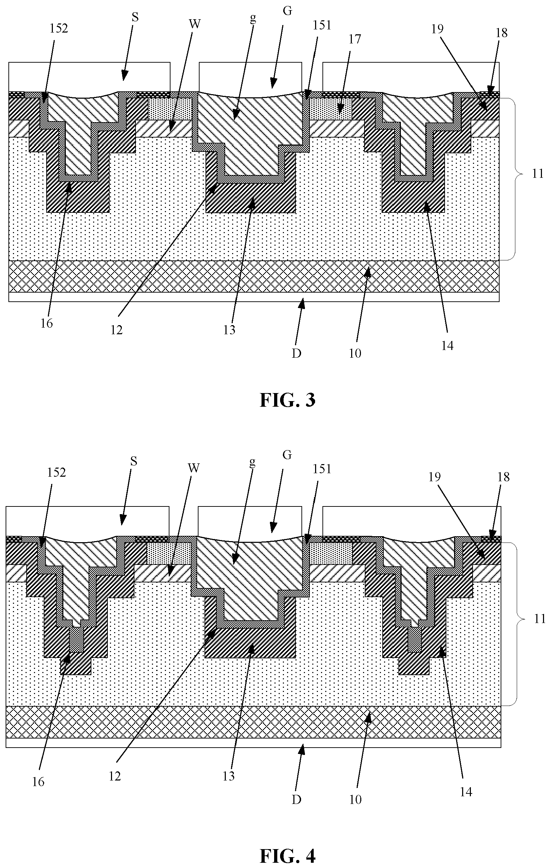

Reference is made to FIG. 3, which is a structural schematic diagram of a silicon carbide semiconductor device according to an embodiment of the present disclosure. The silicon carbide semiconductor device comprises: a silicon carbide epitaxial layer 11, a first trench 12, a first voltage-resistant shielding structure 13, a gate structure g, a gate metal G, a second voltage-resistant shielding structure 14, a source metal S, and a doped well W. The silicon carbide epitaxial layer 11 comprises a first surface and a second surface that are opposite to each other. The first surface comprises a gate region and a source region located on two sides of the gate region. The first trench 12 is opened on the first surface in the gate region. The first voltage-resistant shielding structure 13 is located in the silicon carbide epitaxial layer 11 and formed through the first trench 12. The gate structure g is located in the first trench 12. The gate metal G is located on a surface of the gate structure. The second voltage-resistant shielding structure 14 is embedded under the first surface in the source region. The source metal S is located on the first surface in the source region. The doped well W is embedded under the first surface and is located between the first trench 12 and the second voltage-resistant shielding structure 14.

In the silicon carbide semiconductor device, the first voltage-resistant shielding structure 13 is formed in the silicon carbide epitaxial layer 11 through the first trench 12, and the second voltage-resistant shielding structure 14 is formed in the source region. Thereby voltage resistance at bottom corners of the first trench 12 is improved, breakdown is less likely to occur at a region subject to high electric field intensity, electrostatic tolerance of the device against harsh environments is improved, and tolerance of the device against high-voltage spikes in circuitry is improved. Moreover, forming the first voltage-resistant shielding structure 13 through the first trench 12 can increase a depth of ions implanted for forming the first voltage-resistant shielding structure. Hence, a variety of trench gate protection structures and anti-surge designs can be achieved.

In addition, a thick insulating dielectric layer can be fabricated at a bottom of the trench, which addresses the issue that a thick silicon dioxide layer cannot be formed at the bottom of the trench through oxidation in common high-temperature furnace tubes. Hence, the voltage resistance at the bottom of the trench can be further improved, which increases reliability of the device.

In an embodiment, the silicon carbide epitaxial layer 11 is fabricated on a surface of a semiconductor substrate 10, and the second surface faces the semiconductor substrate 10. A drain metal D is located on a surface of the semiconductor substrate 10 away from the silicon carbide epitaxial layer 11. The source metal S and the drain metal D may comprise Ti, Al, or the like. The drain metal D may comprise one of Ni, Ti, Al, and Ag, or may comprises a composite metallic layer comprising multiple of Ni, Ti, Al, and Ag.

Dopants in the silicon carbide epitaxial layer 11 have the same polarity as dopants of the semiconductor substrate 10. Dopants in the doped well W, the first voltage-resistant shielding structure 13, and the second voltage-resistant shielding structure 14 have the same polarity, and such polarity is opposite to that of the dopants in the silicon carbide epitaxial layer 11. P-doping and n-doping have dopants of opposite polarities. The silicon carbide epitaxial layer 11 comprises an ion-implanted region 17 located on a side of the doped well W facing the first surface. Dopants in the ion-implanted region 17 and the dopants of the doped well W have opposite polarities. In a case that the doped well W is p-doped, the ion-implanted region 17 may be n-doped.

The semiconductor substrate 10 may be an n+ (heavily n-doped) silicon carbide substrate. The silicon carbide epitaxial layer 11 may be an n- (lightly n-doped) silicon carbide epitaxial layer and serve as a drift region of the semiconductor device. The doped well W may be a p-well. The first voltage-resistant shielding structure 13 and the second voltage-resistant shielding structure 14 comprise a p+ (heavily p-doped) ion-implanted region. Herein polarity of dopants in each region in the device is not limited to the above examples and may be configured on requirement to form a PMOS or NMOS structure.

Along a depth direction of the first trench, the first voltage-resistant shielding structure 13 is located on a side of the doped well W facing the second surface. The first voltage-resistant shielding structure 13 does not contact the doped well W. That is, the first voltage-resistant shielding structure 13 is located below the doped well W along a vertical direction as shown in FIG. 3 and has no contact with the doped well W.

In an embodiment as shown in FIG. 3, the first trench 12 is a first two-level stair trench (i.e., stair-like trench comprising two step-levels). The gate structure g comprises polysilicon that fills the first trench 12, and a first insulating dielectric layer 151 is disposed between a surface of the first trench 12 and the polysilicon. The first voltage-resistant shielding structure 13 comprises a doped region embedded under a side surface and a bottom surface of a level, which is closer to the second surface, of the first two-level stair trench. The first insulating dielectric layer 151 may be a gate oxide layer, e.g., silicon dioxide.

The first two-level stair trench comprises two levels and a step-like structure between the two levels. One level of the first two-level stair trench is close to the first surface, and the other level is close to the second surface. Opening of the level close to the first surface is larger than opening of the level close to the second surface. Under masking of a sacrificial layer located on a side surface of the level close to the first surface, ions are implanted via the first two-level stair trench to form the first voltage-resistant shielding structure 13. Hence, it is avoided that scattered ions are implanted into the side surface of the level close to the first surface, so that the first voltage-resistant shielding structure 13 is located below the doped well W and is prevented from contacting the doped well W. Accordingly, a channel the semiconductor device would not be turned on abnormally, which ensures normal operation of the device.

The first insulating dielectric layer 151 may extend out of the first trench 12 and cover the first surface. An opening configured to accommodate a metallic ohmic contact layer 18 is provided in the first insulating dielectric layer 151 on the first surface. The source metal S is connected to the silicon carbide epitaxial layer 11 via the metallic ohmic contact layer 18 in the opening.

A depth of the doped well W with respect to the first surface is less than a depth of a step surface (i.e., a top surface of step-like structure) between the two levels of the first two-level stair trench. The first voltage-resistant shielding structure 13 is located on a side of the step surface facing the second surface.

In an embodiment as shown in FIG. 3, a multi-level stair trench 16 is located in the source region. The multi-level stair trench 16 may be filled with polysilicon, and a second insulating dielectric layer 152 is located between a surface of the multi-level stair trench 16 and the polysilicon. The second voltage-resistant shielding structure 14 comprises a doped region, which is formed through the multi-level stair trench, in the silicon carbide epitaxial layer 11.

The first insulating dielectric layer 151 on the surface of the first trench 12 and the second insulating dielectric layer 152 on the surface of the multi-level stair trench 16 may comprise a same material and may be fabricated in a same process. The polysilicon filled in the first trench and the polysilicon filled in the multi-level stair trench 16 may be formed in a same process.

The second voltage-resistant shielding structure 14 comprises a doped region that is in the silicon carbide epitaxial layer 11 and embedded under a side surface of each level, a step surface between every two adjacent levels, a bottom surface, and the first surface surrounding an opening, of the multi-level stair trench 16. That is, the second voltage-resistant shielding structure 14 is located in the silicon carbide epitaxial layer 11 embedded under the side surface of each level, the step surface between every two adjacent levels, the bottom surface, and the first surface surrounding the opening, of the multi-level stair trench 16.

In an embodiment as shown in FIG. 3, the first trench 12 is a first two-level stair trench, and the multi-level stair trench 16 is a second two-level stair trench. The first two-level stair trench and the second two-level stair trench may be identical in depth and fabricated in a same process.

Herein the multi-level stair trench 16 is not limited to the two-level stair trench and may alternatively be a stair trench comprises more than two levels. A quantity of levels in the multi-level stair trench 16 may be configured on a basis of a thickness of the device and a required depth of ion implantation.

In an embodiment, the silicon carbide semiconductor device may be a silicon carbide MOSFET device. In an embodiment as shown in FIG. 3, a trench gate is formed in the gate region on a basis of the first trench 12, and a trench source is formed in the source region on a basis of the multi-level stair trench(es) 16. Each of the first trench 12 and the multi-level stair trench(es) 16 may be the two-level stair trench. In such case, the silicon carbide MOSFET device having a two-level stair trench structure is fabricated.

Reference is made to FIG. 4, which is a schematic structural diagram of a silicon carbide semiconductor device according to another embodiment of the present disclosure. An embodiment as shown in FIG. 4 is illustrated on a basis of an embodiment as shown in FIG. 3. The first trench 12 is the first two-level stair trench, and the multi-level stair trench 16 is a three-level stair trench. A depth of the three-level stair trench is greater than a depth of the first two-level stair trench.

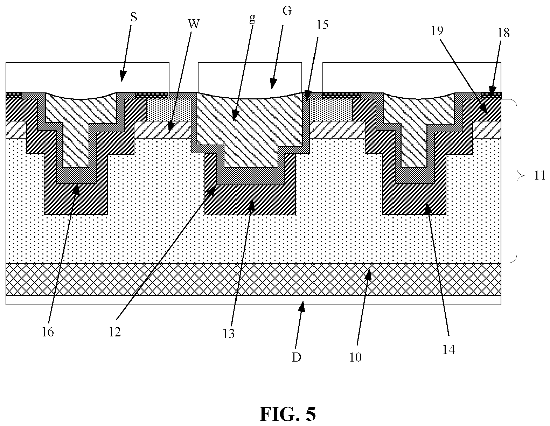

Reference is made to FIG. 5, which is a schematic structural diagram of a silicon carbide semiconductor device according to an embodiment of the present disclosure. In an embodiment as shown in FIG. 5, the first trench 12 is a first two-level stair trench filled with polysilicon, and the gate structure g comprises the polysilicon that fills the first two-level stair trench. The first insulating dielectric layer 151 is located between the surface of the first two-level stair trench and the filled polysilicon. An embodiment as shown in FIG. 5 is illustrated on a basis of an embodiment as shown in FIG. 3. A thickness of the first insulating dielectric layer 151 on a bottom surface of the first two-level stair trench is greater than a thickness of the first insulating dielectric layer 151 on a side surface of each level of the first two-level stair trench and greater than a thickness of the first insulating dielectric layer 151 on a step surface between the two levels of the first two-level stair trench.

In an embodiment as shown in FIG. 5, a thickness of the second insulating dielectric layer 152 at a bottom surface of the multi-level stair trench 16 is greater than a thickness of the second insulating dielectric layer 152 on a side surface of each level of the multi-level stair trench 16 and greater than a thickness of the second insulating dielectric layer 152 on a step surface between every two adjacent levels of the multi-level stair trench 16. The second insulating dielectric layer 152 and the first insulating dielectric layer 151 may be fabricate from a same insulating dielectric layer 15.

It is appreciated that in an embodiment as shown in FIG. 4, the thickness of the first insulating dielectric layer 151 at the bottom surface and the thickness of the second insulating dielectric layer 152 at the bottom surface each may be greater than the thickness of corresponding insulating dielectric layer on other parts of the surface of the corresponding trench.

Thereby, in the silicon carbide semiconductor device, the trench gate is formed in the gate region on a basis of the first trench 12, the trench source is formed in the source region on a basis of the multi-level stair trench 16. The first voltage-resistant shielding structure 13 is formed through implanting ions into the bottom of the first trench 12, and the second voltage-resistant shielding structure 14 is formed through implanting ions into the silicon carbide epitaxial layer 11 at the bottom surface, the side surfaces, and the step surface(s) of the multi-level stair trench 16. Each of the first voltage-resistant shielding structure 13 and the second voltage-resistant shielding structure 14 may be a p+ (heavily p-doped) region.

In such case, the first trench 12 and the multi-level stair trench 16 serve as a window of implanting ions into the silicon carbide epitaxial layer 11 to form the first voltage-resistant shielding structure 13 and the second voltage-resistant shielding structure 14, respectively, which addresses difficulties of forming deep p+ shielding layer in the silicon carbide material. Damages due a large dose and high energy of p+ ion implantation are avoided, which improves reliability of the device. Moreover, the gate trench can be better shielded and protected. After the ions are activated, the first voltage-resistant shielding structure 13 and the second voltage-resistant shielding structure 14 are formed. Then, a silicon dioxide layer is grown on the surface of the first trench 12 and the surface of the multi-level stair trench 16 as the first insulating dielectric layer 151 and the second insulating dielectric layer 152, respectively. Afterwards, the first trench 12 and the multi-level stair trench 16 are filled with the polysilicon. Then, metallic electrodes are formed to complete fabrication of the silicon carbide MOSFET device having the two-level stair trench structure.

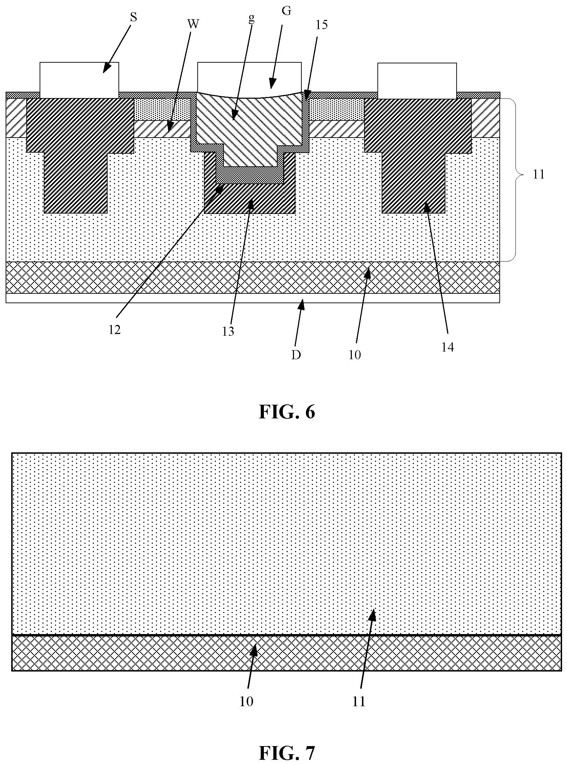

Reference is made to FIG. 6, which is a schematic structural diagram of a silicon carbide semiconductor device according to an embodiment of the present disclosure. The second voltage-resistant shielding structure 14 is an ion-implanted region formed in the source region. In this embodiment, it is not necessary to form a trench in the source region, and the ion-implanted region is directly formed in a certain depth through ion implantation to fabricate the second voltage-resistant shielding structure 14. In an embodiment as shown in FIG. 6, a depth of the ion implantation is greater than or equal to a depth of the first trench 12. Thereby, better voltage-resistant and better shielding can be achieved.

On a basis of the foregoing embodiments, a method for manufacturing a silicon carbide semiconductor device is provided according to embodiments of the present disclosure. The method may be configured to manufacture the silicon carbide semiconductor device described any foregoing embodiment. The method may be illustrated in conjunction with FIG. 7 to FIG. 29.

Reference is made to FIG. 7 to FIG. 29, which are schematic diagrams in a process of a method for manufacturing a silicon carbide semiconductor device according to an embodiment of the present disclosure. The method comprises following steps S11 to S15.

Reference is made to FIG. 7. In step S11, an epitaxial wafer is provided. the epitaxial wafer comprises a silicon carbide epitaxial layer 11. The silicon carbide epitaxial layer 11 comprises a first surface and a second surface that are opposite to each other. The first surface comprises a gate region and a source region that is located on two sides of the gate region.

The silicon carbide semiconductor device may be manufactured on a basis of an n+ silicon carbide semiconductor substrate 10 on which an n- silicon carbide epitaxial layer 11 is provided. The second surface of the silicon carbide epitaxial layer 11 faces the semiconductor substrate 10.

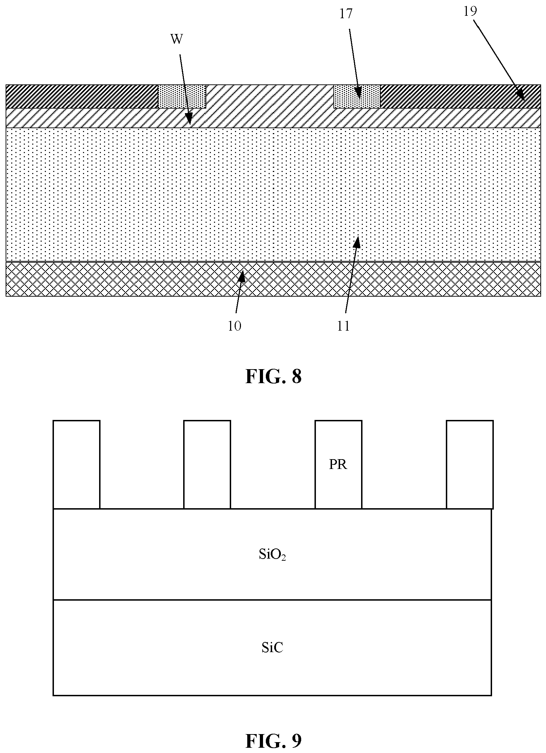

Reference is made to FIG. 8 to FIG. 16. In step S12, a first trench 12 is formed in the gate region.

Before forming the first trench 12, ion may be implanted into the silicon carbide epitaxial layer 11 from the first surface to form a doped well W and form an ion-implanted region 17 and an electric-field buffer region 19. The ion-implanted region 17 and the electric-field buffer region 19 are embedded under the first surface in the source region and are located within the doped well W.

It is taken as an example that a multi-level stair trench 16 is provided in the source region and the second voltage-resistant shielding structure 14 would be formed through the multi-level stair trench 16 in a subsequent step. The electric-field buffer region 19 is configured to suppress leakage and avoids breakdown due to a small thickness of the second voltage-resistant shielding structure 14 at an opening of the multi-level stair trench 16. Hence, manufacturability and reliability of the device are improved. Dopants in the electric field buffer region 19 and dopants in the second voltage-resistant shielding structure 14 have the same polarity, for example, may be for n+ doping. Dopants in the ion-implanted region 17 and the dopants in the second voltage-resistant shielding structure 14 have opposite polarities. As an example, the ion-implanted region 17 may be n+ doped.

It is taken as example that the first trench 12 is a first two-level stair trench and the multi-level stair trench 16 is a second two-level stair trench. The first and second two-level stair trenches may be fabricated simultaneously. A process of forming the first two-level stair trench and the second two-level stair trench may comprise steps S121 to S125.

Reference is made to FIG. 8. In step S121, ions are implanted into the first surface to form the doped well W and form the ion-implanted region 17 and the electric field buffer region 19 in the doped well W.

In a case of silicon carbide materials, the ion implantation is usually performed under temperature ranging from 500°C to 600°C in high-temperature ion-implantation equipment. Thereby, a lattice of the silicon carbide is less damaged.

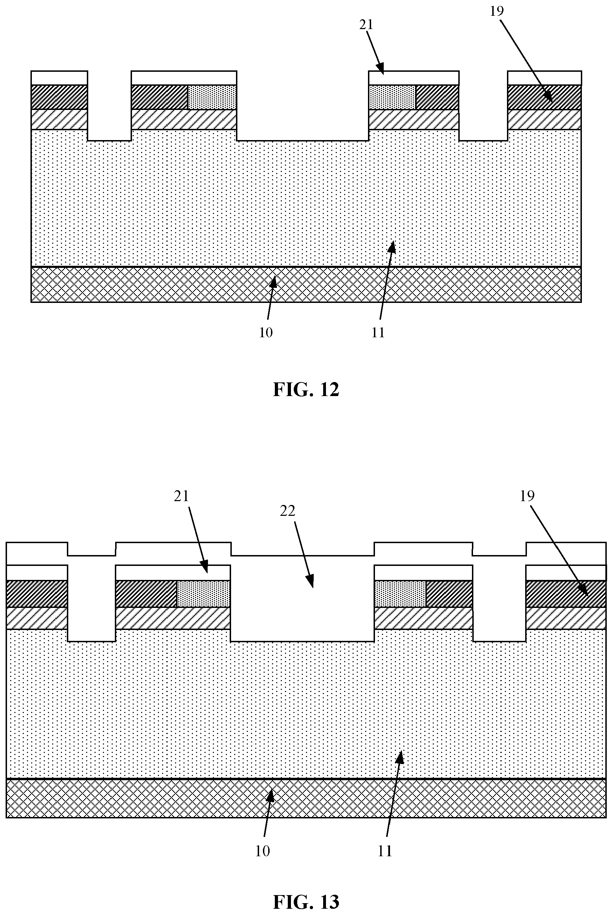

Reference is made to FIG. 12. In step S122, the first surface is etched to form a first-level trench.

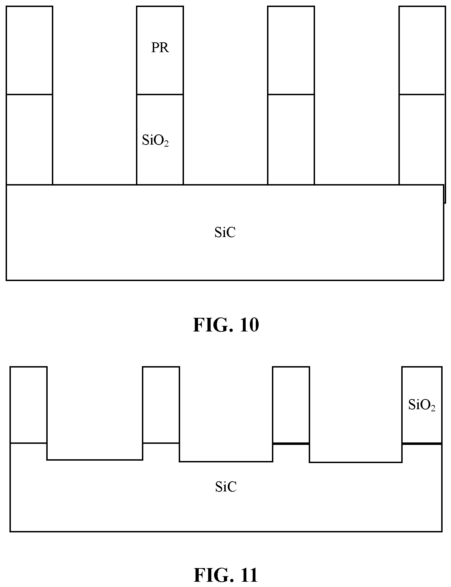

The first-level trench may be formed through plasma dry etching, such as reactive ion etching (RIE) or inductively coupled plasma (ICP) etching. A principle of etching the silicon carbide material may be as shown in FIG. 9 to FIG. 11. As shown in FIG. 9, SiO₂ is first deposited on the silicon carbide material as a mask layer, and the deposition may be, for example, chemical vapor deposition (CVD), a photoresist PR is disposed on a surface of the mask layer through spin coating, and the photoresist PR is then patterned through exposure and development. As shown in FIG. 10, the mask layer is then etched to form a patterned mask layer under masking of the patterned photoresist PR. As shown in FIG. 11, the silicon carbide material is then etched under masking of the patterned mask layer to form trench(es) on the surface of the silicon carbide material. Hereinafter common semiconductor techniques such as photolithography and etching would not be described in detail for subsequent steps.

Reference is made to FIG. 12. When forming the first-level trenches, a SiO₂ layer may be deposited as a mask layer 21 through CVD, and the silicon carbide epitaxial layer 11 is etched by a fluorine-based gas such as CF₄, SF₆, a chlorine-based gas such as chlorine, or a mixture gas of argon and oxygen, in the gate region and the source region through a plasma etching (ICP or RIE) device. Thereby, the first-level trenches are formed in the gate region and the source region. A depth of the first-level trenches ranges from 10nm to 3µm, and specifically may ranges from 800nm to 1µm to improve performances of the device.

Reference is made to FIG. 13. In step S123, the first-level trench is filled with a SiO₂ dielectric layer 22. The SiO₂ dielectric layer 22 may be deposited through CVD. The SiO₂ dielectric layer 22 may fill the first-level trench and cover the mask layer 21.

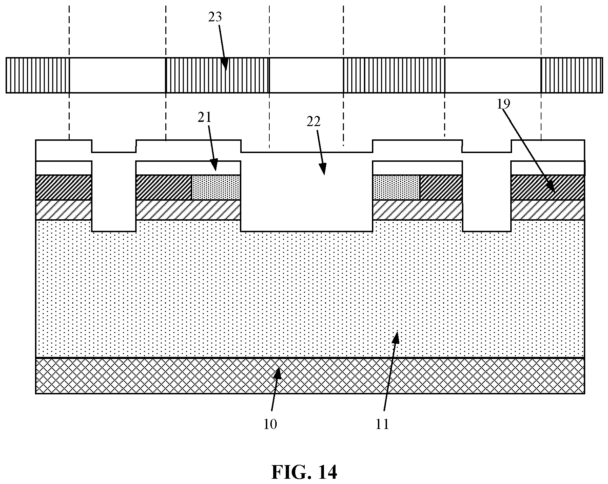

Reference is made to FIG. 14. In step S124, a mask 23 for fabricating second-level trenches is aligned in position.

A photoresist is disposed on a surface of the SiO₂ dielectric layer 22 through spin coating. The photoresist patterned through exposure and development under masking of the mask 23. The photoresist is not depicted in FIG. 14.

A first transmissive region and a second transmissive region is provided in the mask 23. The first transmissive region is configured to form A second-level trench in the gate area for the trench gate, and the second transmissive region is configured to form other second-level trenches in the source region for a trench source. In the mask 23, an opening of the first transmissive region is smaller than an opening of the first-level trench in the gate region, and an opening of the second transmissive region is larger than an opening of the first-level trench in the source region.

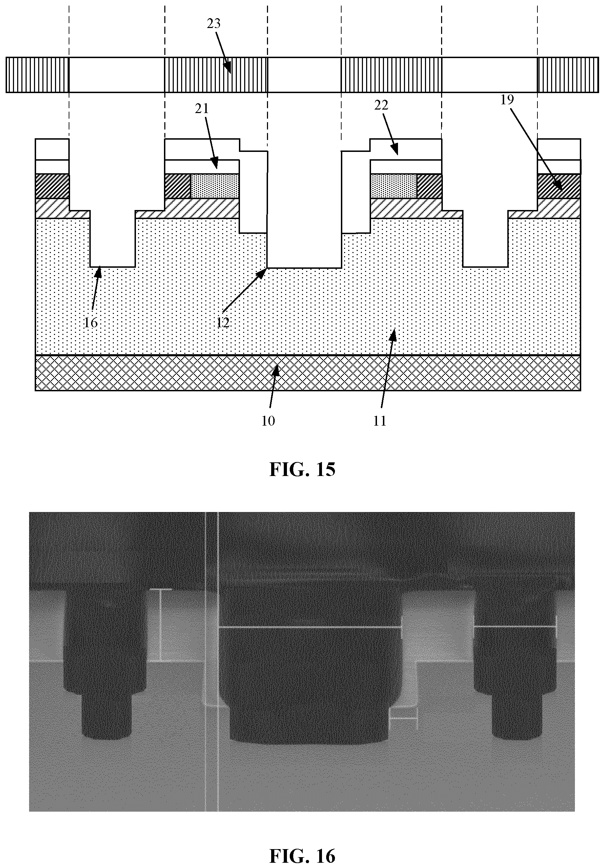

Reference is made to FIG. 15. In step S125, the SiO₂ dielectric layer 22 is etched from the surface under masking of the photoresist to form the second-level trenches on a basis of the corresponding first-level trench in the gate region and the source region, respectively.

The silicon carbide epitaxial layer 11 is etched by a fluorine-based gas such as CF₄, SF₆, a chlorine-based gas such as chlorine, or a mixture gas of argon and oxygen, in the gate region and the source region through a plasma etching (ICP or RIE) device. Thereby, the second-level trenches are formed in the gate region and the source region. A depth of the second-level trenches may range from 100nm to 3um and may specifically range from 300nm to 500nm to improve performances of the device.

Since the opening of the first transmissive region is smaller than the opening of the first-level trench in the gate region, the corresponding second-level trench with a greater depth can be formed through etching at a bottom of the first-level trench in the gate region, and thereby a first two-level stair trench is formed. In such case, when fabricating the first two-level stair trench in the gate region, the SiO₂ dielectric layer 22 on a side surface of the corresponding first-level trench, which is close to the first surface, can be retained as a sacrificial layer. The sacrificial gate can prevent ions from scattering onto the side surface of the first-level trench in the first two-level stair trench during fabrication of the first voltage-resistant shielding structure 13in a subsequent step. Hence, an issue of abnormal turning-on of a channel is addressed, which ensures normal operation of the device and improves reliability of the device.

Since the opening of the second transmissive region is larger than the opening of the first-level trench in the source region, a size of an upper part of the first-level trench is expanded while a depth of the lower part is increased when etching downward, and thereby a second two-level stair trench. In such case, the SiO₂ dielectric layer 22 is removed from a side surface of each level, a step surface between two levels, and a bottom surface, of the second two-level stair trench. After the second two-level stair trench is formed in the source region, ions are implanted into the silicon carbide epitaxial layer 11 on the side surfaces, the step surface, and the bottom surfaces of the second two-level stair trench to form the second voltage-resistant shielding structure 14.

Reference is made to FIG. 16, which is a scanning electron microscopy (SEM) image of two-level stair trenches formed in the source region and the gate region through a method according to an embodiment of the present disclosure. As shown in FIG. 16, the two-level stair trenches in the gate region and the source region have good morphology.

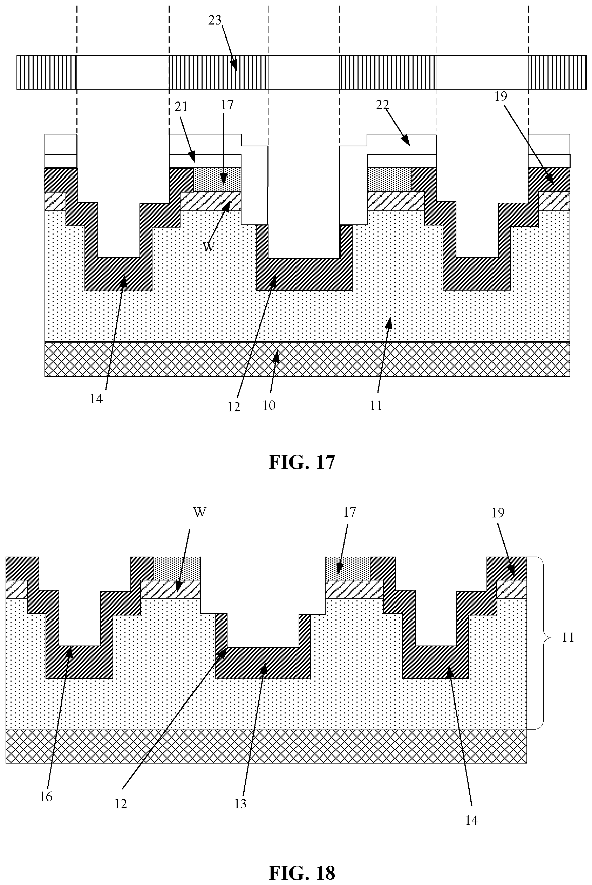

Reference is made to FIG. 17 to FIG. 20. In step S13, the first voltage-resistant shielding structure 13 is formed in the silicon carbide epitaxial layer through the first trench.

The second voltage-resistant shielding structure 14 is embedded under the first surface in the source region. The doped well W is embedded under the first surface and is located between the first trench 12 and the second voltage-resistant shielding structure 14.

The first trench 12 is the first two-level stair trench. A multi-level stair trench 16 may be formed in the source region. A process of forming the first voltage-resistant shielding structure 13 and the second voltage-resistant shielding structure 14 may comprise following steps. Ions are implanted via the first two-level stair trench into a side surface and a bottom surface of the second-level trench, which is close to the second surface in the first two-level stair trench, under masking of the dielectric layer 22 on the sidewall of the first-level trench, which is close to the first surface in the first two-level stair trench. Thereby, the first voltage-resistant shielding structure 13 embedded in the silicon carbide epitaxial layer under the side surface and the bottom surface of the second-level trench in the first two-level stair trench is formed. Ions are implanted via the multi-level stair trench 16 into the side surfaces, the step surface(s), and the bottom surface of the multi-level stair trench 16. Thereby, the second voltage-resistant shielding structure 14 embedded in the silicon carbide epitaxial layer the side surfaces, the step surface(s), and the bottom surface of the multi-level stair trench is formed.

The multi-level stair trench 16 may be configured as the second two-level stair trench, and the depth of the second two-level stair trench is identical to that of the first two-level stair trench. Alternatively, the multi-level stair trench 16 may be configured as a three-level stair trench, and a depth of the three-level stair trench is greater than the depth of the first two-level stair trench.

Reference is made to FIG. 17. In step S13, ions are first implanted under masking of the patterned mask layer 21 and the dielectric layer 22 to form the first voltage-resistant shielding structure 13 and the second voltage-resistant shielding structure 14. High-temperature ion implantation equipment may be utilized to implant the ions of p+ type into the side and bottom surfaces of the trenches under temperature ranging from 500°C to 600°C to form the first voltage-resistant shielding structure 13 and the second voltage-resistant shielding structure 14. Reference is made to FIG. 18. Afterwards, the silicon dioxide mask may be removed by using a buffered HF etchant for wet etching. That is, the mask layer 21 and the dielectric layer 22 is removed.

Generally, the p+ type ions for silicon carbide devices are Al ions. Energy of the ions for implantation has magnitude ranging from 100KeV to 1MeV. A dose of the implanted ions ranges from 1×10¹²cm⁻² to 1×10¹⁶cm⁻². A depth of ion implantation has magnitude ranging from 100 nanometers to 1 micron.

The side surface of the first-level trench in the first two-level stair trench is shielded by the dielectric layer 22 having a thickness ranging from tens of nanometers to hundreds of nanometers or even several micrometers. Hence, the doped well W, which is near the first two-level stair trench and would serve a channel region, is not affected by the implantation of p+ type ions.

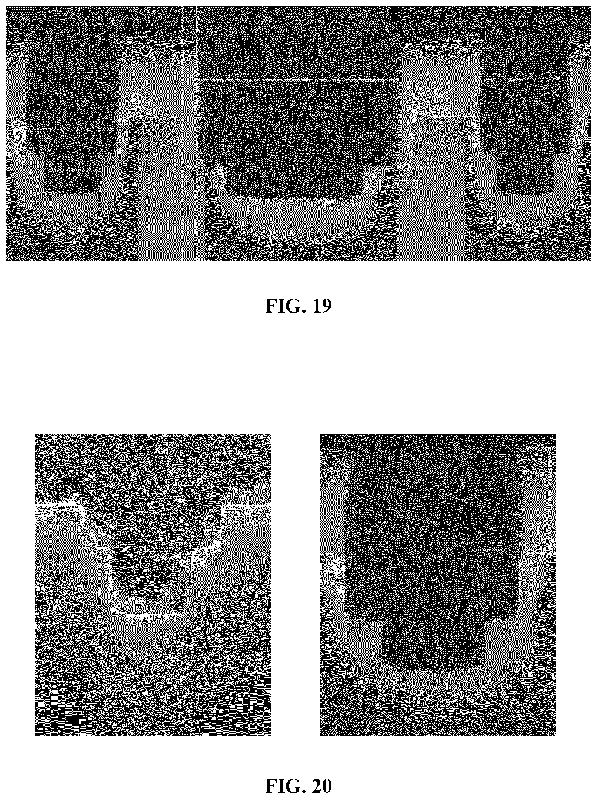

Reference is made to FIG. 19, which is a SEM image after the first voltage-resistant shielding structure 13 and the second voltage-resistant shielding structure 14 have been formed in a method according to an embodiment of the present disclosure. As shown in FIG. 19, after the implantation of p+ type ions, the doped well W serving as the channel region is not affected, thereby improving reliability and stability of the device.

Reference is made to FIG. 20, which are SEM images of the source region before and after the implantation of p+ type ions in a method according to an embodiment of the present disclosure. The left image is a SEM picture of the second two-level stair trench before the ion implantation, while the right image is a SEM picture of the second two-level stair trench after the ion implantation. In the right picture, a region having small grayscale in the SEM image is due to implantation of Al ions.

Thereby, the first two-level stair trench is utilized for the trench gate. Herein the dielectric layer 22 may be retained on the side surface the first-level trench, which is close to the first surface, during fabricating the first two-level stair trench. When ions are implanted via the first two-level stair trench, the p+ type ions are implanted into the bottom and side surfaces of the second-level trench, which is close to the second surface and are prevented from being scattered onto the side surface of the first-level trench. Hence, abnormal turning-on of the channel is avoided in the final trench MOSFET.

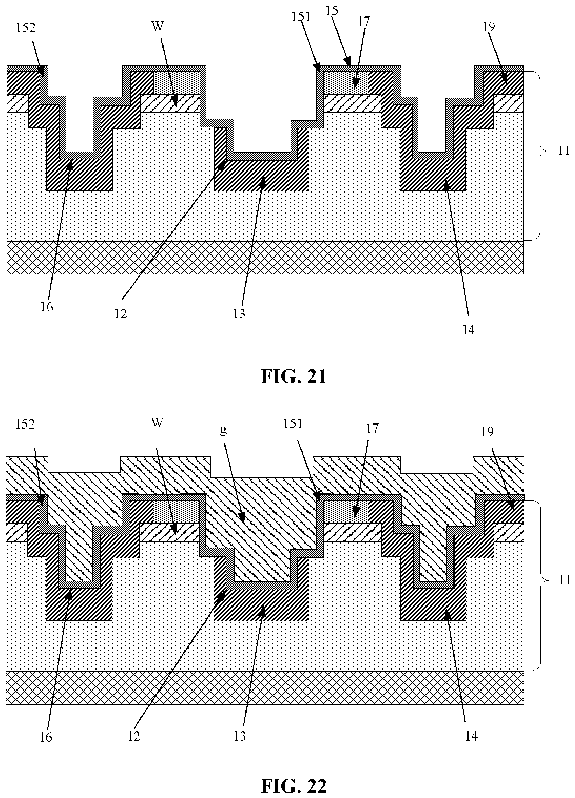

Reference is made to FIGs. 21 to 23. In step S14, a gate structure g is formed in the first trench.

The first trench 12 is the first two-level stair trench, and the multi-level stair trench 16 is formed in the source region. The first two-level stair trench and the multi-level stair trench are filled with polysilicon. The gate structure g comprises the polysilicon filling the first two-level stair trench. An insulating dielectric layer 15 is located between the first two-level stair trench and the corresponding filling polysilicon and between the multi-level stair trench 16 and the corresponding filling polysilicon. The gate structure g comprises the polysilicon filling the first two-level stair trench. A part of the insulating dielectric layer 15 located in the first trench 12 serves as the first insulating dielectric layer 151 and serves as a gate dielectric layer of the trench gate. Another part of the insulating dielectric layer 15 located in the multi-level stair trench 16 serves as the second insulating dielectric layer 152.

Reference is made to FIG. 21. In the step S14, the insulating dielectric layer 15 may be first formed to cover the first surface, the surface of the first trench 12, and the surface of the multi-level stair trench 16. The insulating dielectric layer in the first trench 12 serves as the gate dielectric layer of the trench gate. In an embodiment, the insulating dielectric layer 15 is a SiO₂ layer. The insulating dielectric layer 15 may be grown in a high-temperature furnace tube. For example, oxygen is introduced into the high-temperature furnace tube at temperature ranging from 1100°C to 1350°C, and hence SiO₂ is formed through oxidizing the first surface, and the surface of the first trench 12, and the surface of the multi-level stair trench 16. Thereby, the insulating dielectric layer 15 is formed. A thickness of the insulating dielectric layer 15 may range from 40nm to 70nm.

Reference is made to FIG. 22. After the insulating dielectric layer 15 has been formed, the first trench 12 and the multi-level stair trench 16 are filled with polysilicon. The polysilicon may be formed in a following manner. A gas of silane or dichlorosilane (DCS), an Ar gas, and a doping gas comprising phosphorus or boron such as phosphorane or borane, are introduced into a low-pressure chemical vapor deposition (LPCVD) furnace tube at temperature ranging from 540°C to 800°C, such that polysilicon is formed through chemical cracking. A thickness of the polysilicon may range from 400nm to several microns.

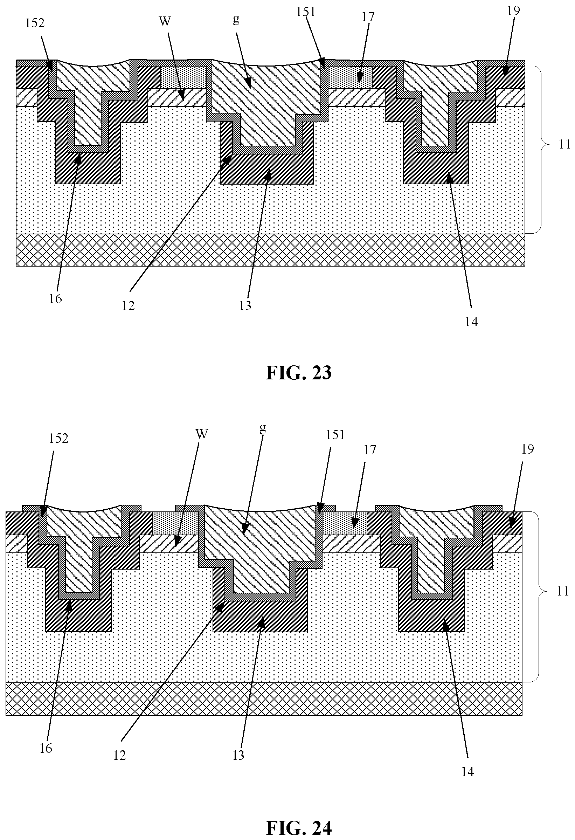

Reference is made to FIG. 23. A mixture gas comprising HBr, chlorine, and oxygen may be utilized to etch the polysilicon, such that the polysilicon over the first surface is removed.

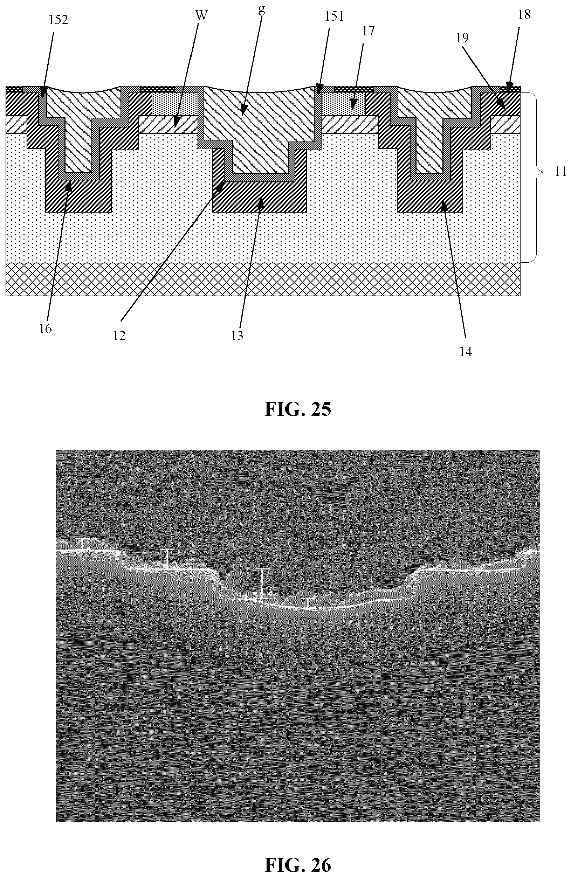

Reference is made to FIG. 24 and FIG. 25. In step S15, a gate metal is formed on a surface of the gate structure g, and a source metal is formed on a surface of the source region. Thereby, a silicon carbide semiconductor device as shown in FIG. 3 can be formed.

The gate metal G is located on the surface of the polysilicon filling the first two-level stair trench. The source metal S is located on the surface of the polysilicon filling the multi-level stair trench 16.

Reference is made to FIG. 24. In step S15, the insulating dielectric layer 15 on the first surface is removed through etching to form opening(s) exposing the first surface. The first insulating dielectric layer 15 in a predetermined area of the source region may be etched through a fluorine-based gas such as CHF₃ and CF₄ or a chlorine-based to form the opening(s).

Reference is made to FIG. 25. A metallic ohmic contact layer 18 is formed in the opening(s) in the first insulating dielectric layer 15 to reduce contact impedance between the source metal S and the first surface. The metallic ohmic contact layer 18 may be formed through following steps. A single layer of Ni or multiple metal layers such as Ti/Ni/Al are deposited in the source region through PVD. Then, the layer(s) outside of the source region are removed through stripping or etching. Afterwards, the layer(s) are subject to rapid thermal annealing at temperature ranging from 900°C to 1100°C. Duration of the annealing may range from 30 seconds to 5 minutes.

Afterwards, a gate metal G is formed on the surface of the trench gate, a source metal S is formed on the surface of the trench source, and a drain metal D is formed on a surface of the semiconductor substrate 10 away from the silicon carbide epitaxial layer 11. Thereby, the silicon carbide semiconductor device as shown in FIG. 3 is manufactured. Herein the processing on metals such as the gate metal and the source meal, the processing concerning a passivation layer and polyimide (PI), and processing on the drain metal may all utilize common techniques, which are not illustrated in detail.

It is taken as an example in FIGs. 7 to 25 that the first trench 12 is the first two-level stair trench and the source region has the second two-level stair trench. In such case, the silicon carbide semiconductor device as shown in FIG. 3 may be manufactured. In conventional single-level trenches, when being implanted into the bottom surface, the p+ type ions are also implanted into an upper side surface of the first two-level stair trench due to scattering of the mask and the side surface. Hence, a voltage-resistant shielding structure is connected to the doped well that serves as the channel region, thereby causing abnormal turning-on of a channel. Such issue is addressed in the silicon carbide semiconductor device as shown in FIG. 3.

On a basis of the process as shown in FIGs. 7 to 25, a silicon carbide MOSFET device having a two-level stair trench structure may be formed, where two-level stair trenches may be formed in the gate region and the source region. In an embodiment, the first two-level stair trench is formed in the gate region for forming the trench gate, and the second two-level stair trench is formed in the source region for forming the trench source. A first voltage-resistant shielding structure 13 is formed in the silicon carbide epitaxial layer 11 at the bottom surface and the side surface of the level of the first two-level stair trench close to the second surface, and the second voltage-resistant shielding structure 14 is formed in the silicon carbide epitaxial layer 11 under the bottom surface, the side surfaces, and each step surface of the second two-level stair trench. The two two-level stair trenches facilitate addressing difficulties of fabricating deep p+ shielding layers in the silicon carbide material. Thereby, low reliability due to damages caused by a high dose and high energy of implanting p+ type ions is avoided, and the trench gate can be better shielded and protected.

High-energy and high-dose ion implantation with a depth larger than a range from 1 um to 2um is apt to induce serious damages to the silicon carbide material and reduce reliability of long-term operation of final devices. Herein the trench source may be formed through the two-level stair trench in the source region, and hence a p+ electric-field shielding structure can be easily implanted at a depth larger than the range from 1 um to 2um in the source region. Hence, the side and bottom surfaces of the trench gate are better protected, and reliability of the gate is improved for the silicon carbide MOSFET device.

In addition, in a conventional trench gate fabricated based on a single-level trench, when being implanted into the bottom surface, the p+ type ions are also implanted into an upper side surface of the first two-level stair trench due to scattering of the mask and the side surface. Hence, a voltage-resistant shielding structure is connected to the doped well that serves as the channel region, thereby causing abnormal turning-on of a channel. the trench gate having the two-level stair trench structure can further address the following issue.

Herein concepts concerning the silicon carbide semiconductor device having the two-level stair trench structure and its manufacturing method may be expanded to a multi-level stair trench structure. In such case, the p+ type ions may be injected deeper, the gate may be better shielded from an electric field, and a semi-super-junction structure may be formed. Hence, a three-level stair trench may be formed in the source region to achieve the deeper distribution of the p+ type ions and form a deeper second voltage-resistant shielding structure 14 in the source region. In such case, the p+ shielding and protection structure in the source region can extend deeper, and the silicon carbide semiconductor device as shown in FIG. 4 may be manufactured. Reference is made to FIG. 26, which is a SEM image of a three-level stair trench according to an embodiment of the present disclosure.

In another embodiment, a process of forming the second voltage-resistant shielding structure 14 comprises following steps. An ion-implanted region is formed in the source region through ion implantation, where the ion-implanted region serves as the second voltage-resistant shielding structure 14. A depth of the ion implantation is greater than or equal to a depth of the first trench. Thereby, the silicon carbide semiconductor device as shown in FIG. 6 may be manufactured. In such case, the two-level stair trench structure is formed only in the gate region, and the second voltage-resistant shielding structure 14 is formed through high-energy and high-dose implantation of the p+ type ions in the source region, thereby shielding and protecting the trench gate from electric fields. Processing in such case may refer to that for the structure as shown in FIG. 3 and would not be repeated herein.

In another embodiment, a thickness of the insulating dielectric layer 15 on the bottom surface of the first two-level stair trench is configured to be greater than a thickness of the insulating dielectric layer 15 on the side surface of each level of the first two-level stair trench and greater than a thickness of the insulating dielectric layer 15 on the step surface between two levels of the first two-level stair trench. Moreover, a thickness of the insulating dielectric layer 15 at the bottom surface of the multi-level stair trench 16 is greater than a thickness of the insulating dielectric layer 15 on the side surface of each level of the multi-level stair trench 16 and greater than a thickness of the insulating dielectric layer 15 on the step surface between every two adjacent levels in the multi-level stair trench 16. Thereby, the silicon carbide semiconductor device as shown in FIG. 5 may be manufactured.

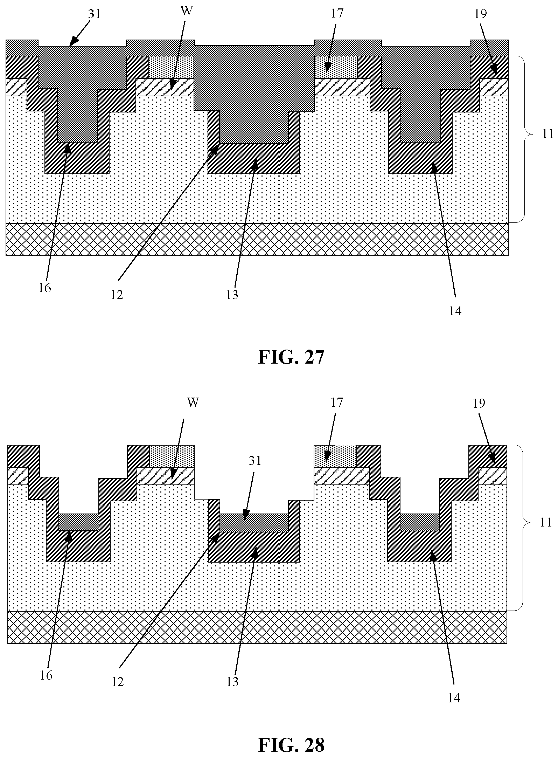

Processing and structures as shown in FIG. 7 to FIG. 25 may be further selectively optimized. After the first voltage-resistant shielding structure 13 and the second voltage-resistant shielding structure 14 are formed through ion implantation and high temperature activation, SiO₂ may be first formed through CVD to fill the trenches in the gate region and the source region, and then the SiO₂ in the trenches and on the first surface are etched back through plasma etching (e.g., ICP etching or RIE) by a gas having high selectivity between SiO₂ and SiC. Thereby, SiO₂ on the first surface and in levels of the first and second two-level stair trenches close to the first surface are removed through the etching, and SiO₂ at bottoms of the first and second two-level stair trenches are retained. Afterwards, more SiO₂ is grown on the side surfaces through a high-temperature furnace tube, and then the polysilicon is filled. Thereby, the insulating dielectric layer formed at the bottom of the first and second two-level stair trenches is thicker, which further increases voltage resistance of the gate dielectric layer at a bottom of the trench gate and improves reliability of the device. The above process may refer to FIGs. 27 to 29 as follows.

Reference is made to FIG. 27. On a basis of the structure shown in FIG. 18, the two-level stair trenches in the gate region and the source region are first filled with a SiO₂ layer 31. A dense SiO₂ layer 31 may be deposited on the surfaces of the two-level stair trenches through thermal oxidation in a furnace tube, for example, through tetraethoxysilane (TEOS) or high thermal oxidation (HTO), in which a gas of SiH₄ or DCS reacts with a gas of NO or O₂ to form SiO₂.

Reference is made to FIG. 28. The SiO₂ layer 31 on the first surface and tin the two-level stair trenches are etched, where the SiO₂ layer 31 with a predetermined thickness is retained in levels of the trenches close to the second surface. The etching may be plasma etching using a gas having high selectivity between SiO₂ and SiC, such as C₄F₈. The SiO₂ layer 31 is etched back until the retain SiO₂ layer 31 on the bottom surface of levels of the trenches close to the second surface has the predetermined thickness.

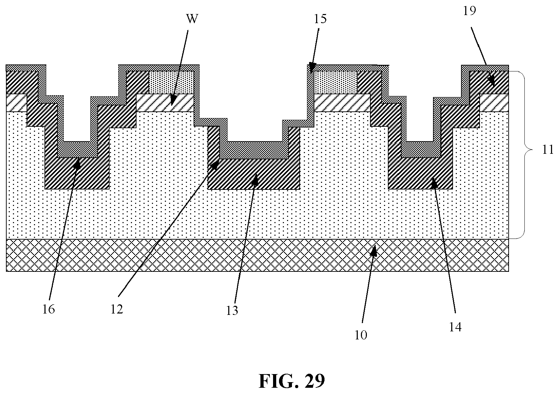

Reference is made to FIG. 29. Another SiO₂ layer is grown on the first surface and the surfaces of the two-level stair trenches. Oxygen is introduced into a high-temperature furnace tube at temperature ranging from 1100°C to 1350°C to grow such SiO₂ layer having a thickness ranging from 40nm to 70nm. Such SiO₂ layer and the previous SiO₂ layer 31 retained at the bottom of the trenches form the insulating dielectric layer 15.

The insulating dielectric layer 15 formed at the bottom of the trenches through the process as shown in FIG. 27 to FIG. 29 is thicker. Hence, voltage resistance at the bottom of the trench gate is improved, and reliability of the device is further improved.

The embodiments of the present disclosure are described in a progressive manner, a parallel manner, or a combination of the two. Each embodiment places emphasis on the difference from other embodiments. Therefore, one embodiment can refer to other embodiments for the same or similar parts. For the device disclosed in the embodiment, since it corresponds to the method disclosed in the embodiment, the description is relatively simple, and the relevant parts can be referred to the method part description.

Herein the description of the drawings and embodiments is illustrative rather than restrictive. The same reference numeral throughout embodiments of the present disclosure presents the same structure. In addition, for the sake of understanding and ease of description, the drawings may exaggerate the thickness of some layers, films, panels, regions, or the like. When an element such as a layer, film, region, or substrate is described to be "on" another element, the element may be directly on the other element or there may be an intermediate element between the two. In addition, "on" means positioning an element above or below another element, and such positioning does not necessarily refer to positioning on an upper side of the other element with respect to a direction of gravity.

Herein terms indicating orientation or a positional relationship, such as "up", "low", "top", "bottom", "inner", "outer", and the like, are based on the orientation or the positional relationship as shown in the drawings. These terms are only intended for facilitating and simplifying description of the present disclosure, and do not explicitly or implicitly indicate that concerning devices or elements must have a specific orientation or must be constructed and operated based on a specific orientation. Therefore, the orientation or the positional relationship shall not be construed as a limitation on the present disclosure. In a case that a component is described to be "connected" to another component, it may be connected directly to the other component, or there may be an intermediate component between the two.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article, or a device including a series of elements include not only the disclosed elements but also other elements that are not clearly enumerated, or further include inherent elements of the process, the method, the article, or the device. Unless expressively limited, the statement "including a..." does not exclude the case that other similar elements may exist in the process, the method, the article, or the device other than enumerated elements.

According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to the widest scope in accordance with principles and novel features disclosed in the present disclosure.

## Claims

1. A silicon carbide semiconductor device, comprising:
a silicon carbide epitaxial layer, wherein the silicon carbide epitaxial layer comprises a first surface and a second surface that are opposite to each other, the first surface comprises a gate region and a source region located on two sides of the gate region;
a first trench, opened at the first surface in the gate region;
a first voltage-resistant shielding structure, located in the silicon carbide epitaxial layer and formed through the first trench;
a gate structure, located in the first trench;
a gate metal, located on a surface of the gate structure;
a second voltage-resistant shielding structure, embedded under the first surface in the source portion;
a source metal, located on the first surface in the source region; and
a doped well, embedded under the first surface and located between the first trench and the second voltage-resistant shielding structure.

2. The silicon carbide semiconductor device according to claim 1, wherein along a depth direction of the first trench,
the first voltage-resistant shielding structure is located on a side of the doped well facing the second surface; and
the first voltage-resistant shielding structure does not contact the doped well.

3. The silicon carbide semiconductor device according to claim 1, wherein:
the first trench is a first two-level stair trench;
the gate structure comprises polysilicon filling the first trench, and a first insulating dielectric layer is located between a surface of the first trench and the polysilicon; and
the first voltage-resistant shielding structure comprises a doped region embedded under a side surface and a bottom surface of a level, which is close to the second surface, of the first two-level stair trench.

4. The silicon carbide semiconductor device according to claim 3, wherein:
with respect to the first surface, a depth of the doped well is less than a depth of a step surface between two levels of the first two-level stair trench; and
the first voltage-resistant shielding structure is located on a side of the step surface facing the second surface.

5. The silicon carbide semiconductor device according to claim 1, wherein:
the first trench is a first two-level stair trench;
the first two-level stair trench is filled with polysilicon, and a first insulating dielectric layer is located between a surface of the first two-level stair trench and the polysilicon; and
a thickness of the insulating dielectric layer on a bottom surface of the first two-level stair trench is greater than:
a thickness of the insulating dielectric layer on side surfaces of two levels of the first two-level stair trench, and
a thickness of the insulating dielectric layer at a step surface between the two levels of the first two-level stair trench.

6. The silicon carbide semiconductor device according to claim 1, wherein:
a multi-level stair trench is located under the first surface in the source region;
the multi-level stair trench is filled with polysilicon, and a second insulating dielectric layer is located between a surface of the multi-level stair trench and the polysilicon; and
the second voltage-resistant shielding structure comprises a doped region located in the silicon carbide epitaxial layer and formed through the multi-level stair trench.

7. The silicon carbide semiconductor device according to claim 6, wherein:
the first trench is a first two-level stair trench, the multi-level stair trench is a second two-level stair trench, and a depth of the first two-level stair trench is identical to a depth of the second two-level stair trench.

8. The silicon carbide semiconductor device according to claim 6, wherein:
the first trench is a first two-level stair trench, the multi-level stair trench is a three-level stair trench, and a depth of the three-level stair trench is greater than a depth of the first two-level stair trench.

9. The silicon carbide semiconductor device according to claim 6, wherein the second voltage-resistant shielding structure comprises a doped region of the silicon carbide epitaxial layer embedded under:
a side surface of each level, a step surface between every two adjacent levels, a bottom surface, and the first surface surrounding an opening,
of the multi-level stair trench.

10. The silicon carbide semiconductor device according to claim 6, wherein a thickness of the second insulating dielectric layer on a bottom surface of the multi-level stair trench is greater than:
a thickness of the second insulating dielectric layer on a side surface of each level of the multi-level stair trench, and
a thickness of the second insulating dielectric layer on a step surface between every two adjacent levels of the multi-level stair trench.

11. The silicon carbide semiconductor device according to claim 1, wherein the second voltage-resistant shielding structure is embedded under the first surface in the source region and implanted with ions.

12. The silicon carbide semiconductor device according to claim 11, wherein a depth of implanting the ions is greater than or equal to a depth of the first trench.

13. A method for manufacturing the silicon carbide semiconductor device according to any one of claims 1 to 12, comprising:
providing an epitaxial wafer, wherein the epitaxial wafer comprises a silicon carbide epitaxial layer, the silicon carbide epitaxial layer comprises a first surface and a second surface that are opposite to each other, the first surface comprises a gate region and a source region located on two sides of the gate region;
forming a first trench in the gate region;
forming a first voltage-resistant shielding structure in the silicon carbide epitaxial layer through the first trench;
forming a gate structure in the first trench; and
forming a gate metal on a surface of the gate structure, and forming a source metal on a surface of the source region;
wherein a second voltage-resistant shielding structure is embedded under the first surface in the source region, and a doped well is embedded under the first surface and located between the first trench and the second voltage-resistant shielding structure.

14. The method according to claim 13, wherein the first trench is a first two-level stair trench, and a multi-level stair trench is formed in the source region, and forming the first voltage-resistant shielding structure and forming the second voltage-resistant shielding structure comprises:
implanting, via the first two-level stair trench and under masking of a dielectric layer located on a side surface of another level of the first two-level stair trench close to the first surface, ions into a side surface and a bottom surface of a level, which is close to the second surface, of the first two-level stair trench to form the first voltage-resistant shielding structure embedded under the side surface and the bottom surface of the level of the first two-level stair trench; and
implanting, via the multi-level stair trench, ions into a bottom surface, a step surface between every two adjacent levels, and a side surface of each level, of the multi-level stair trench to form the second voltage-resistant shielding structure in the silicon carbide epitaxial layer, wherein the second voltage-resistant shielding structure is embedded under the bottom surface, the one or more step surfaces, and the side surfaces of the multi-level stair trench.

15. The method according to claim 13, wherein:
the first trench is a first two-level stair trench, and a multi-level stair trench is formed in the source region;
the first two-level stair trench and the multi-level stair trench are filled with polysilicon;
the gate structure comprises the polysilicon filling the first two-level stair trench;
an insulating dielectric layer is disposed between a surface of the first two-level stair trench and the polysilicon filling the first two-level stair trench and between a surface of the multi-level stair trench and the polysilicon filling the multi-level stair trench;
the gate structure comprises the polysilicon filling the first two-level stair trench; and
the gate metal is disposed on a surface of the polysilicon filling the first two-level stair trench, and the source metal is disposed on a surface of the polysilicon filling the multi-level stair trench.

16. The method according to claim 15, wherein:
a thickness of the insulating dielectric layer on a bottom surface of the first two-level stair trench is greater than a thickness of the insulating dielectric layer on side surfaces of two levels of the first two-level stair trench and a thickness of the insulating dielectric layer on a step surface between the two levels; and
a thickness of the insulating dielectric layer on a bottom surface of the multi-level stair trench is greater than a thickness of the insulating dielectric layer on a side surface of each level of the multi-level stair trench and a thickness of the insulating dielectric layer on a step surface between every two adjacent levels of the multi-level stair trench.

17. The method according to claim 16, wherein:
the multi-level stair trench is a second two-level stair trench, and a depth of the second two-level stair trench is identical a depth of the first two-level stair trench, or
the multi-level stair trench is a three-level stair trench, and a depth of the three-level stair trench is greater than a depth of the first two-level stair trench.

18. The method according to claim 13, wherein forming the second voltage-resistant shielding structure comprises:
performing ion implantation on the source region to form an ion-implanted portion, which serves as the second voltage-resistant shielding structure, wherein a depth of the ion implantation is greater than or equal to a depth of the first trench.
